# EUROPEAN PATENT SPECIFICATION

(11) **EP 3 866 335 B1**
(45) Date of publication and mention of the grant of the patent: **03.08.2022**
(21) Application number: 19856449.4
(22) Date of filing: 20.12.2019
(51) Int. Cl.: H02S 40/44, H01L 31/048

(54) **HYBRID SOLAR PANEL FOR PRODUCING ELECTRICAL ENERGY AND THERMAL ENERGY**
HYBRIDE SOLARPLATTE ZUR ERZEUGUNG VON ELEKTRISCHER ENERGIE UND THERMISCHER ENERGIE
PANNEAU SOLAIRE HYBRIDE POUR LA PRODUCTION D'ÉNERGIE ÉLECTRIQUE ET D'ÉNERGIE THERMIQUE

(30) Priority: 04.01.2019 ES 201930007
(43) Date of publication of application: 18.08.2021
(73) Proprietor: ABORA ENERGY, S.L., 50016 Zaragoza (ES)
(72) Inventor: DEL AMO SANCHO, Alejandro, 50196 La Muela / Zaragoza (ES); CAÑADA GRACIA, Marta, 50196 La Muela / Zaragoza (ES); ZÁRATE ÁVILA, Vicente, 50196 La Muela / Zaragoza (ES)
(74) Representative: Pons
(86) International application number: PCT/ES2019/070870
(87) International publication number: WO 2020/141241

(56) References cited:
- DE-A1- 2 622 511
- US-A1- 2008 302 357
- US-A1- 2016 013 343
- Shin-Etsu Chemical Co. ET AL: "Characteristic properties of Silicone Rubber Compounds", , 28 May 2015 (2015-05-28), pages 1-16, XP055481360, Retrieved from the Internet: URL:https://web.archive.org/web/2015052821 1210if_/http://www.shinetsusilicone-global .com:80/catalog/pdf/rubber_e.pdf [retrieved on 2018-06-05]

## Description

### DESCRIPTION

### OBJECT OF THE INVENTION

The present invention discloses a hybrid solar panel for producing electrical energy and thermal energy. More particularly, the present invention discloses a panel which allows increasing the maximum working temperatures, as well as the electrical and thermal efficiency, increasing its durability, eliminating problems with delamination and degradation, and furthermore allowing the elimination of superfluous layers affecting the overall efficiency of the panel.

### BACKGROUND OF THE INVENTION

The use of hybrid panels for producing electrical and thermal energy is known in the state of the art.

A hybrid solar (PVT) panel is, by definition or in essence, a solar energy collector using a photovoltaic layer as an absorber. The more incident irradiation on the photovoltaic layer that can be transferred in the form of heat to the fluid, the greater its thermal efficiency, furthermore increasing the electrical efficiency of the photovoltaic layer, and thereby the overall efficiency and the energy produced, by cooling.

Hybrid solar technology is characterised by generating electrical (photovoltaic) energy and thermal energy (thermal collectors) in one same panel. Hybrid solar panels are generally known as PVT (photovoltaic-thermal) panels.

Photovoltaic modules lose around 85% of the energy they receive. The first developments of hybrid (PVT-1, WISC or unglazed) panels sought to take advantage of this unused energy. To that end, they incorporated a recuperator in a photovoltaic panel on its rear face and insulated it from the environment. These developments thereby recovered the heat that was lost on the rear face. This technology presents a problem associated with its thermal efficiency, since this efficiency drops significantly when its working temperature increases, with only 5-10% being in applications of domestic hot water.

The International Energy Agency (IEA) developed in 2002 a state of the art and a roadmap for photovoltaic technology, laying out the future work for this purpose in Task 7. Later, over the years 2005-2010, the IEA promoted an in-depth analysis of existing technologies and the potential market for hybrid panels in Task 35 (http://archive.iea-shc.org/task35/). The purpose was to catalyse the introduction of this technology onto the market. Among its conclusions, it should be pointed out that it proposes different lines to be developed, such as: the improvement of optics and thermal efficiency.

The thermal absorbers for PVT modules are complementary to solar cells as another way to use solar energy. The overall conversion efficiency of a PVT module increases with the efficiency of its thermal absorber according to the laws of thermodynamics. Different methods for thermal absorption design, namely, sheet-and-tube structure, rectangular tunnel with or without fins/grooves, flat-plate tube, microchannels/heat mat, extruded heat exchanger, roll-bond, and cotton wick structure, are being widely developed. (Wu, 2017).

The PVT can be split by the working fluid: air, water, coolant, phase change material, nanofluid, etc.). They are also characterised by the type of PV module: flat plate, flexible or concentrator, and also by different technologies such as monocrystalline and polycrystalline silicon, amorphous silicon, CaTe, CIGS, organics, perovskites.

In the design of a PVT, the integration of the photovoltaic layer with the absorber represents a critical element. Thermal efficiency, service life, product costs and the cooling of the PV layer will depend on it. One of the reasons is that the thermal resistance between the PV layer and the thermal absorber may come to be extremely large if there are air bubbles or a small air gap in the integration layer. Therefore, both the thermal absorber and the method of integration used are critical for PVT modules since they directly affect the cooling of the photovoltaic layers and, therefore, the electrical/thermal/overall efficiency as well.

Of all the thermal absorbers and methods of integration compared in the review by Jinshun Wu (Wu, 2017), the most suitable are the lamination method based on the recuperator and photovoltaic lamination based on Ethyl Vinyl Acetate (EVA).

The manufacture of photovoltaic laminates known in the state of the art for hybrid solar panels is performed with an encapsulant called ethyl vinyl acetate (EVA) which fixes the photovoltaic cells in place and adheres them to a glass on the front face and to a rear layer known as backsheet which generally has Tedlar and another equivalent as the main component.

For example, Spanish patent ES244990B1 discloses a hybrid solar panel for producing electrical and photovoltaic energy, disclosing an intermediate layer of gas or a certain degree of vacuum increasing the thermal efficiency of the panel by means of reducing convective heat losses. Said patent application discloses the junction between the photovoltaic system and the heat absorber by means of a conductive adhesive or any type of joining system which allows conductive heat exchange therebetween.

Likewise, patent application DE 2622511 A1 discloses a hybrid solar panel, disclosing an intermediate chamber, where it does not specify whether said chamber presents a certain degree of vacuum or the presence of a gas. In any case, said hybrid panel does not disclose the material or the type of junction of the photovoltaic system and heat absorber, with said feature being essential in panels of this type with regard to the overall efficiency and service life of the panel.

In the state of the art known by the applicant, this joining is predominantly performed by lamination with EVA. Direct contact, mechanical fixing or thermal adhesive are also known but they are less commonly used and unfavourable.

The maximum working temperature of EVA is 80-85°C. Exceeding this temperature entails problems with delamination between the different layers in which EVA is used: photovoltaic cells with glass, EVA or cells with the backsheet and backsheet with a recuperator. Delamination has an effect on both aesthetics and on the electrical and thermal efficiency.

A hybrid solar panel increases its stagnation temperature the higher its thermal efficiency is, which is desirable. This means that in circumstances where the panel is in stagnation (with no circulation of fluid inside same), its temperature can exceed 150°C. Accordingly, there is a technical practical limit which affects the service life and the overall efficiency in hybrid panels laminated with EVA.

The EVA used for encapsulating photovoltaic cells and for joining the photovoltaic laminate with the recuperator experiences degradation throughout its service life for a number of reasons (Cândida Carvalho de Oliveira, 2018): high temperatures, UV radiation, moisture, poor crosslinking in the manufacturing process and contamination of the material.

There are many consequences of this degradation. Firstly, efficiency throughout the service life gradually drops over the years. The thermal energy is also reduced insofar as the junction between the photovoltaic laminate and the recuperator deteriorates. Secondly, potential-induced degradation (PID) takes place. The service life of these panels is about 25 years with a loss of power of 20-25% in cases of good product and operating quality of the installation. It also gives rise to aesthetic problems such as yellowing, discolouration, bubbles and delamination.

State of the art patent application US 2016/013343A discloses hybrid solar panels with an encapsulation layer comprising a silicone encapsulant and a thermal conductive insulating layer which comprises a thermally conductive silicone.

Prior art document [US 2008/302357A] discloses solar panels with different thermal conductive materials to bond solar cells tom a heat exchanger.

Shin-Etsu Chemical Co.ET AL:" Characteristic properties of Silicone Rubber compounds" describes an informative brochure from large silicone rubber manufacturers for electronic applications, describing a thermal conductivity of rubbers in the range 0.2 W/m k and further disclosing high transparency silicone rubbers.

### DESCRIPTION OF THE INVENTION

The present invention intends to solve some of the problems mentioned in the state of the art.

The present invention is described in claim 1. More in particular, it discloses a hybrid solar panel for producing electrical energy and thermal energy, comprising:
- a photovoltaic power generation system, with at least one photovoltaic cell,
- a heat absorber for evacuating heat from the photovoltaic generation system by means of a heat transfer fluid, thus increasing its electrical efficiency.
- a transparent insulating cover sealed along the perimeter to the photovoltaic generation system,
- an intermediate layer of vacuum, air or inert gas between the photovoltaic generation system and the transparent insulating cover.
- a lower insulating layer located below the heat absorber,
- a perimeter frame with a rear sheet or a casing comprising the four sides of the perimeter and the rear part,
- wherein the hybrid solar panel additionally comprises a junction for joining the photovoltaic power generation system with the heat absorber, the junction comprising two layers of material with a silicone base, where a first layer comprises encapsulating silicone inside the photovoltaic generation system and projecting above said photovoltaic generation layer, the encapsulating silicone presenting a refractive index of less than 1.45 and an optical transmission index greater than 98%, and a second layer located above and adjacent to the heat absorber and comprising a thermal adhesive silicone with a thermal conductivity greater than 0.2 W/ m·K.

Preferably the layer of thermal adhesive silicone comprises an oxide particle load in the order of 1-200 µm, where said oxide particle load allows the material with a silicone base to reach thermal conductivities of up to 3 W/ m·K. Silicone-based methods or particles of another type, which allow increasing the thermal conductivity of said layer with the knowledge already disclosed in the state of the art in other sectors or applications and are obvious to one skilled in the art tasked with the objective problem of increasing the thermal conductivity of a material with a silicone base, can be used.

The thermal adhesive silicone can present rapid curing at room temperature by adding a platinum catalyst with a ratio of 5:1 to 20:1. Preferably, said ratio can be 10:1 by weight or volume. Preferably, the encapsulating silicone comprises a pourable two-component silicone that vulcanises into a soft elastomer, at a mixture ratio of 10:1. This allows for the necessary elastic properties in said layer of encapsulating silicone to protect the assembly against expansions due to the different expansion coefficients of each material in each layer of the panel.

The encapsulating silicone can present rapid curing by means of adding a catalyst with a ratio of 5:1 to 20:1. In addition to the amount of mixture, the curing time will depend on other factors such as the thermal conductivity of the encapsulated components, and the UV light present.

A panel can present a tempered glass located above the layer of encapsulating silicone. The panel of the present invention, however, is devoid of said tempered glass due to the high optical transmission and low refractive indices of the layer of encapsulating silicone. A panel can present a layer of Tedlar between the layer of encapsulating silicone and the layer of thermal adhesive silicone. The panel of the present invention, however, is devoid of said layer of Tedlar, since the metal heat absorber can provide sufficient rigidity for the hybrid panel.

It must be noted that the layer of thermal adhesive silicone can reach working temperatures without being damaged of up to 250°C with respect to the known limit of 80°C in the state of the art by using EVA as the material for joining the photovoltaic generation system with the heat absorber.

The thermal conductivity of the layer of thermal adhesive is 0.2 - 3 W/m·K depending on the addition of oxide particles or other particles or methods known in the state of the art for obtaining a silicone with a higher thermal conductivity in other applications or sectors, in contrast with the thermal conductivity of EVA of about 0.13 W/m·K. It must further be added that by means of the present invention the layer of Tedlar, also known in the art as "backsheet", is eliminated, thus eliminating a heat conduction barrier for the photovoltaic cells. The mentioned factors represent a significant increase in thermal efficiency, accordingly increasing the electrical efficiency of the photovoltaic system.

Likewise, the lower refractive index and higher optical transmission of silicone in the encapsulation layer with respect to the materials known in the state of the art allow for a higher amount of incident solar radiation (along the entire spectrum) to reach both the photovoltaic cells and the surface of the recuperator, allowing an increase both in electrical production and in thermal production. This applies both to the areas covered with photovoltaic cells and to the free spaces therebetween. With the elimination of tempered glass from the photovoltaic layer, lower reflection losses and therefore a higher overall efficiency would be possible.

Additionally, resistance to UV radiation of the layers with silicone bases is very high with respect to the material known in the state of the art for carrying out said function, with this material being EVA (ethyl vinyl acetate). The moisture content of silicone-based materials is 0.03% with respect to 0.3% in EVA.

The presence of corrosion due to corrosive agents such as the acetic acid present in photovoltaic panels laminated with EVA is the main source of failures and losses of efficiency in photovoltaic panels throughout their service life. Said loss of efficiency considered optimal in the current state of the art is in the order of 20-25% over 20-25 years. The corrosion of silicon-based material in the photovoltaic layer at high temperatures and low UV radiation in the present invention is negligible compared with the use of EVA.

The absence of corrosive agents such as the acetic acid in EVA, the very high resistance to ultraviolet radiation and the lower moisture content eliminate problems with degradation derived from this material, increasing the service life of 25 years up to 40 years, additionally featuring an enormous further advantage which is a lower loss of efficiency over the years.

This increase in service life in the order of 1.5- to 2-fold, as well as the increase in electrical and thermal production due to the resulting increase in efficiencies implies an increase in the economic efficiency of the product.

Another important aspect to be pointed out is that due to the lower hardness, deformation and tensile strength values, the present invention favours the flexible adaptation of the joined layers despite the different coefficients of expansion of each material. For hybrid solar panels, these features are extremely important due to the large and constant variations in temperature inside the panel, and therefore the expansions that occur.

Not subjecting the set of layers to high-temperature heat processes during the manufacturing process also prevents deformation in this first step. Being able to remove conventional glass from photovoltaic lamination is also important to prevent the assembly from bending due to differences between the coefficients of expansion of the different materials.

### DESCRIPTION OF THE DRAWINGS

To complement the description that is being made and for the purpose of helping to better understand the features of the invention according to a preferred practical embodiment thereof, a set of drawings is attached as an integral part of said description in which the following is depicted in an illustrative and non-limiting manner:
Figure 1 shows a side section view of the hybrid panel according to a first embodiment of the present invention in which the embodiment without a backsheet and without a layer of glass adjacent to the photovoltaic generation system is clearly shown.
Figure 2 shows a side section view of the hybrid panel according to a second embodiment of the present invention in which the embodiment without a backsheet and with the layer of glass adjacent to the photovoltaic generation system is clearly shown.
Figure 3 shows a side section view of the hybrid panel not according to the present invention, wherein the backsheet and the layer of glass are present, adjacent to the photovoltaic generation system.

### PREFERRED EMBODIMENT OF THE INVENTION

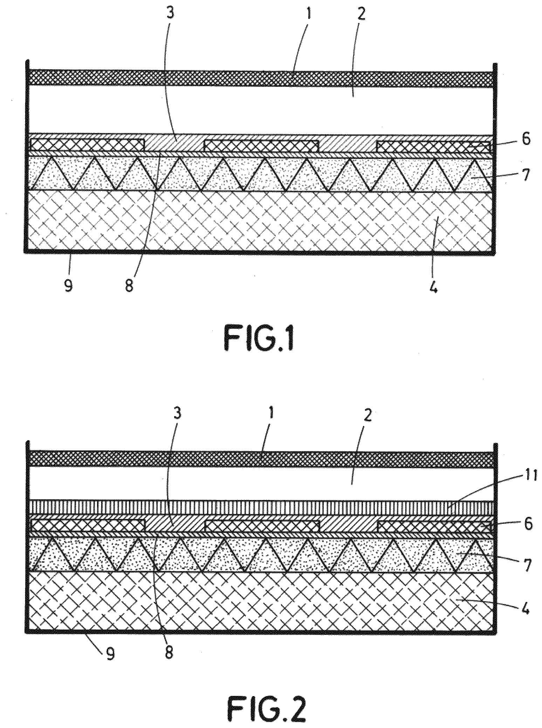

Figure 1 shows a side section view of the hybrid panel according to a first embodiment of the present invention in which a transparent insulating cover (1) sealed along the perimeter in the upper part of the panel can be seen, with said insulating cover (1) being located immediately above an intermediate layer (2) of vacuum, air or inert gas. Located adjacent to and below said intermediate layer (2) is the layer of encapsulating silicone (3) having an optical transmission greater than 98% and a refractive index of less than 1.45. Said layer of encapsulating silicone (3) allows the junction between photovoltaic cells (6) and projects above said cells. Located immediately adjacent to and below said layer of encapsulating silicone (3) and the photovoltaic power generation system (6) is the second layer of material with a silicone base, the layer of thermal adhesive (8), having thermal conductivities in the order of 0.2 - 3 W/m*K, allowing the junction of the set of photovoltaic cells (6) with a heat absorber (7), facilitating the transfer of heat to a heat transfer fluid (going through the absorber), thereby increasing the electrical efficiency of the photovoltaic system (6) and furthermore increasing the thermal efficiency by means of thermal conductivities in the thermal adhesive silicone (8) that are higher than those of the materials known in the state of the art for this function. The layer of thermal adhesive silicone (8) has an oxide particle load in the order of 1-200 µm.

Finally, the lowest part of the panel has an insulating layer (4) bordering the perimeter frame (9) forming the outside of the hybrid photovoltaic thermal generation panel.

Figure 2 shows a side section view of the hybrid panel according to a second embodiment of the present invention in which a transparent insulating cover (1) sealed along the perimeter in the upper part of the panel can be seen, with said insulating cover (1) being located immediately above an intermediate layer (2) of vacuum, inert gas or air. Located adjacent to said intermediate layer (2) is tempered glass (11) joined by means of a layer of encapsulating silicone (3) having an optical transmission greater than 98% and a refractive index of less than 1.45. Said layer of encapsulating silicone (3) allows the junction between photovoltaic cells (6) and projects above said cells. Located immediately adjacent to and below said layer of encapsulating silicone (3) and the photovoltaic power generation system (6) is the second layer of material with a silicone base, the layer of thermal adhesive (8), having thermal conductivities in the order of 0.2 - 3 W/m*K, allowing the junction of the set of photovoltaic cells (6) with a heat absorber (7), allowing the transfer of heat to a heat transfer fluid, thereby increasing the electrical efficiency of the photovoltaic system (6) and furthermore increasing the thermal efficiency by means of thermal conductivities in the thermal adhesive silicone (8) that are higher than those of the materials known in the state of the art for this function. Finally, the lowest part of the panel has an insulating layer (4) bordering the perimeter frame (9) forming the outside of the hybrid photovoltaic thermal generation panel.

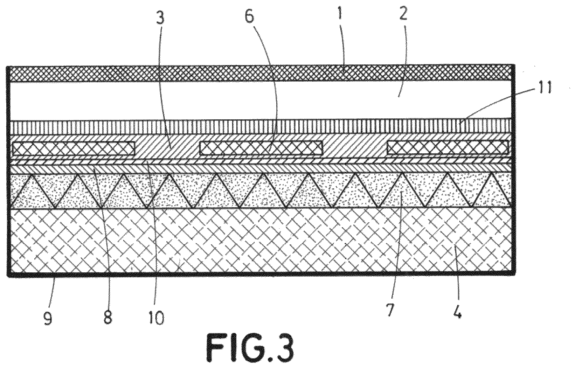

Figure 3 shows a side section view of the hybrid panel not according to the present invention, in which a transparent insulating cover (1) sealed along the perimeter in the upper part of the panel can be seen, with said insulating cover (1) being located immediately above an intermediate layer of vacuum, inert gas or air (2). Located adjacent to said intermediate layer (2) is tempered glass (11) joined by means of a layer of encapsulating silicone (3) having an optical transmission greater than 98% and a refractive index of less than 1.45. Said layer of encapsulating silicone (3) allows the junction between photovoltaic cells (6) and projects above said cells. Located immediately adjacent to and below said layer of encapsulating silicone (3) is a layer of backsheet (10). Said layer of backsheet is joined to a heat absorber (7) by means of a second layer of material with a silicone base, said layer being the layer of thermal adhesive (8), having thermal conductivities in the order of 0.2 - 3 W/m*K, as well as a high heat transfer by means of a heat transfer fluid, thereby increasing the electrical efficiency of the photovoltaic system (6) and furthermore increasing the thermal efficiency by means of thermal conductivities in the thermal adhesive silicone (8) that are higher than those of the materials known in the state of the art for this function. Finally, the lowest part of the panel has an insulating layer (4) bordering the perimeter frame (9) forming the outside of the hybrid photovoltaic thermal generation panel.

## Claims

1. A hybrid solar panel for producing electrical energy and thermal energy, comprising:
- a photovoltaic power generation system (6), with at least one photovoltaic cell,
- a heat absorber (7) for evacuating heat from the photovoltaic generation system (6) by means of a heat transfer fluid,
- a transparent insulating cover (1) sealed along the perimeter to the photovoltaic generation system,
- an intermediate layer (2) of vacuum, inert gas or air between the photovoltaic generation system and the transparent insulating cover (1),
- a lower insulating layer (4) located below the heat absorber (7),
- a perimeter frame (9) with a rear sheet or a casing comprising the four sides of the perimeter and the rear part,
wherein it additionally comprises a junction for joining the photovoltaic power generation system (6) with the heat absorber, the junction comprising two layers of material with a silicone base, where a first layer comprises encapsulating silicone (3) inside the photovoltaic generation system (6) and projecting above said photovoltaic generation layer (6), the encapsulating silicone (3) presenting a refractive index of less than 1.45 and an optical transmission index greater than 98%, and the junction further comprising a second layer of a thermal silicone (8) with a thermal conductivity greater than 0.2 W/ m·K,
**characterized in that** said thermal silicone (8) is located above and adjacent to the heat absorber (7) so that the junction joins the photovoltaic power generation system (6) with the heat absorber (7) devoid of a backsheet (10) therebetween and thus eliminating a heat conduction barrier for the photovoltaic cells,

2. - The hybrid solar panel for producing electrical energy and thermal energy according to claim 1, **characterized in that** it is devoid of a tempered glass (11) between the intermediate layer (2) and the encapsulating silicone (3) yielding lower reflection losses.

3. - The hybrid solar panel for producing electrical energy and thermal energy according to claim 2, **characterised in that** the encapsulating silicone (3) presents a curing by means of adding a catalyst with a ratio of 5:1 to 20:1.

4. - The hybrid solar panel for producing electrical energy and thermal energy according to any of claims 1-3, **characterised in that** the encapsulating silicone (3) comprises a pourable two-component silicone that vulcanises into an elastomer, at a mixture ratio of 10:1.

5. The hybrid solar panel for producing electrical energy and thermal energy according to claim 4, **characterised in that** the thermal encapsulating silicone (8) presents a curing at room temperature by means of adding a platinum catalyst with a ratio of 5:1 to 20:1.

## Patentansprüche

1. Hybridsolarpanel zum Erzeugen von Strom und Wärmeenergie, das Folgendes umfasst:
- eine fotovoltaische Stromerzeugungsanlage (6) mit mindestens einer fotovoltaischen Zelle,
- einen Wärmeaufnehmer (7) zum Ableiten von Wärme aus der fotovoltaischen Erzeugungsanlage (6) mittels eines Wärmetransferfluids,
- eine durchsichtige Isolierabdeckung (1), die entlang des Umfangs der fotovoltaischen Erzeugungsanlage abgedichtet ist,
- eine Vakuum-, Inertgas- oder Luft-Zwischenschicht (2) zwischen der fotovoltaischen Erzeugungsanlage und der durchsichtigen Isolierabdeckung (1),
- eine untere Isolierschicht (4), die unter dem Wärmeaufnehmer (7) liegt,
- einen Umfangsrahmen (9) mit einer hinteren Platte oder einem Gehäuse, das die vier Seiten des Umfangs und des Rückseitenteils umfasst,
wobei es zusätzlich eine Verbindungsstelle zum Verbinden der fotovoltaischen Erzeugungsanlage (6) mit dem Wärmeaufnehmer umfasst, wobei die Verbindungsstelle zwei Schichten aus Material mit einer Silikonbasis umfasst, wobei eine erste Schicht Kapselungssilikon (3) innerhalb der fotovoltaischen Erzeugungsanlage (6) umfasst und über der fotovoltaischen Erzeugungsanlage (6) vorragt, wobei das Kapselungssilikon (3) einen Brechungsindex von weniger als 1,45 und einen Lichtübertragungsindex größer als 98 % aufweist, und die Verbindungsstelle weiter eine zweite Schicht aus einem thermischen Silikon (8) mit einer Wärmeleitfähigkeit größer als 0,2 W/m·K umfasst,
**dadurch gekennzeichnet, dass** das thermische Silikon (8) über dem Wärmeaufnehmer (7) und an ihn angrenzend derart liegt, dass die Verbindungsstelle die fotovoltaische Erzeugungsanlage (6) mit dem Wärmeaufnehmer (7) ohne Rückseitenplatte (10) dazwischen verbindet und somit eine Wärmeleitungsbarriere für die fotovoltaische Zelle eliminiert.

2. Hybridsolarpanel zum Erzeugen von Strom und Wärmeenergie nach Anspruch 1, **dadurch gekennzeichnet, dass** es kein Hartglas (11) zwischen der Zwischenschicht (2) und dem Kapselungssilikon (3) aufweist, was niedrigere Reflexionsverluste ergibt.

3. Hybridsolarpanel zum Erzeugen von Strom und Wärmeenergie nach Anspruch 2, **dadurch gekennzeichnet, dass** das Kapselungssilikon (3) ein Härten mittels Hinzufügens eines Katalysators mit einem Verhältnis von 5:1 bis 20:1 aufweist.

4. Hybridsolarpanel zum Erzeugen von Strom und Wärmeenergie nach einem der Ansprüche 1-3, **dadurch gekennzeichnet, dass** das Kapselungssilikon (3) ein fließfähiges Zweikomponenten-Silikon mit einem Mischverhältnis von 10:1 umfasst, das in ein Elastomer vulkanisiert.

5. Hybridsolarpanel zum Erzeugen von Strom und Wärmeenergie nach Anspruch 4, **dadurch gekennzeichnet, dass** das thermische Kapselungssilikon (8) ein Härten bei Raumtemperatur mittels Hinzufügens eines Platinkatalysators mit einem Verhältnis von 5:1 bis 20:1 aufweist.

## Revendications

1. Panneau solaire hybride pour la production d'énergie électrique et d'énergie thermique, comprenant :
- un système de génération de puissance photovoltaïque (6), avec au moins une cellule photovoltaïque,
- un absorbeur de chaleur (7) pour l'évacuation de chaleur depuis le système de génération photovoltaïque (6) au moyen d'un fluide de transfert de chaleur,
- une couverture isolante transparente (1) scellée le long du périmètre au système de génération photovoltaïque,
- une couche intermédiaire (2) de vide, de gaz inerte ou d'air entre le système de génération photovoltaïque et la couverture isolante transparente (1),
- une couche isolante inférieure (4) située sous l'absorbeur de chaleur (7),
- un cadre de périmètre (9) avec une feuille arrière ou un boîtier comprenant les quatre côtés du périmètre et la partie arrière,
dans lequel il comprend en plus une jonction pour joindre le système de génération de puissance photovoltaïque (6) avec l'absorbeur de chaleur, la jonction comprenant deux couches de matériau avec une base de silicone, où une première couche comprend de la silicone encapsulante (3) à l'intérieur du système de génération photovoltaïque (6) et faisant saillie au-dessus de ladite couche de génération photovoltaïque (6), la silicone encapsulante (3) présentant un indice de réfraction de moins de 1,45 et un indice de transmission optique supérieur à 98 %, et la jonction comprenant en outre une seconde couche d'une silicone thermique (8) avec une conductivité thermique supérieure à 0,2 W/ m·K,
**caractérisé en ce que** ladite silicone thermique (8) est située au-dessus et adjacente à l'absorbeur de chaleur (7) de sorte que la jonction joint le système de génération de puissance photovoltaïque (6) avec l'absorbeur de chaleur (7) dépourvu d'une feuille arrière (10) entre ceux-ci et éliminant donc une barrière de conduction de chaleur pour les cellules photovoltaïques.

2. Panneau solaire hybride pour la production d'énergie électrique et d'énergie thermique selon la revendication 1, **caractérisé en ce qu'**il est dépourvu d'un verre trempé (11) entre la couche intermédiaire (2) et la silicone encapsulante (3) entraînant des pertes de réflexion inférieures.

3. Panneau solaire hybride pour la production d'énergie électrique et d'énergie thermique selon la revendication 2, **caractérisé en ce que** la silicone encapsulante (3) présente un durcissement au moyen de l'ajout d'un catalyseur avec un rapport de 5:1 à 20:1.

4. Panneau solaire hybride pour la production d'énergie électrique et d'énergie thermique selon l'une quelconque des revendications 1 à 3, **caractérisé en ce que** la silicone encapsulante (3) comprend une silicone versable à deux composants qui se vulcanise en un élastomère, à un rapport de mélange de 10:1.

5. Panneau solaire hybride pour la production d'énergie électrique et d'énergie thermique selon la revendication 4, **caractérisé en ce que** la silicone encapsulante thermique (8) présente un durcissement à température ambiante au moyen de l'ajout d'un catalyseur de platine avec un rapport de 5:1 à 20:1.
